# EUROPEAN PATENT APPLICATION

(11) **EP 4 839 063 A1**
(43) Date of publication of application: **11.11.2026**
(21) Application number: 24922518.6
(22) Date of filing: 21.06.2024
(51) Int. Cl.: H10H 20/00

(54) **LIGHT-EMITTING ELEMENT AND DISPLAY DEVICE USING SAME**

(30) Priority: 30.01.2024 KR 20240014293
(71) Applicant: LG Electronics Inc., Yeongdeungpo-gu Seoul 07336 (KR)
(72) Inventor: CHOI, Byeongjun, Seoul 06772 (KR); KIM, Seonock, Seoul 06772 (KR); BYUN, Sangwook, Seoul 06772 (KR); YUH, Hwankuk, Seoul 06772 (KR)
(74) Representative: Vossius & Partner Patentanwälte Rechtsanwälte mbB
(86) International application number: PCT/KR2024/008581
(87) International publication number: WO 2025/164852

(57) **Abstract**

The present invention can be applied to the technical field related to a display device, and relates to a light-emitting element such as a light-emitting diode (LED), and a display device using same. The present invention may comprise: a support structure; a semiconductor structure which is positioned on the support structure, and which includes a first conductive semiconductor layer, a light-emitting layer that is positioned on the first conductive semiconductor layer, and a second conductive semiconductor layer that is positioned on the light-emitting layer and includes an expanded region with an area expanded to be larger than that of the light-emitting layer, the expanded region having a first surface that defines a light-emitting surface, and a second surface opposite to the first surface; a first electrode positioned on the first conductive semiconductor layer; a reflective electrode which is in contact with the first electrode and which has an extended area having a first contact part; a second electrode having a second contact part in contact with the second surface; and a passivation layer, which includes a region between the reflective electrode and the second electrode and is positioned on at least one surface of the semiconductor structure.

## Description

### [Technical Field]

The present invention is applicable to the technical field related to a display device, and for example, relates to a light-emitting element such as a light emitting diode (LED) and a display device using the same.

### [Background art]

Recently, in a field of a display technology, display devices having excellent characteristics such as thinness, flexibility, and the like have been developed. On the other hand, currently commercialized major displays are represented by a LCD (liquid crystal display) and an OLED (organic light emitting diode).

On the other hand, LED (light emitting diode), which is a well-known semiconductor light emitting element that converts electric current into light, has been used as a light source for a display image of an electronic device including an information and communication device along with a GaP:N-based green LED, starting with commercialization of a red LED using a GaAsP compound semiconductor in 1962.

Recently, the light-emitting diode (LED) has been gradually miniaturized to be manufactured into a micrometer-sized LED which is used as a pixel of the display device.

The LED exhibits characteristics of low power, high luminance, and high reliability compared to other types of display elements/panels, and may be applied to a flexible element. Therefore, research thereon has been actively conducted in research institutes and companies in recent years.

In general, in order to secure luminance of a display using a small light-emitting element, for example, one micro LED as a subpixel, it is advantageous for an LED chip itself to have excellent optical efficiency.

As a size of a device decreases, an area of a side wall relative to an active area may increase, current leakage may increase, and optical efficiency may decrease. Thus, when a light-emitting element is used in a display, it may be difficult to implement high luminance.

Even when a method of increasing optical efficiency by forming roughness on the device itself is adopted, a large amount of light escapes to a lower portion and a side surface of the device. Thus, in a display in which front luminance is important, a method for further increasing optical efficiency is required.

In addition, red, green, and blue light-emitting elements are made of different semiconductor thin film materials, and thus have different light emission distributions for respective viewing angles, which may cause a problem in that colors appear differently for respective viewing angles in a display.

In a structure in which a display is manufactured by connecting wiring to an upper portion of a device, there is a problem in that it is difficult to use a flip-chip structure. When lower wiring is connected in order to use the flip-chip structure, bonding needs to be performed through a solder material, and spreading of the solder material during bonding may cause a short-circuit defect between two electrodes of the device. Therefore, when a flip-chip structure is manufactured in a display, a minimum distance between the two electrodes should be secured, and thus it may be difficult to reduce a size of the device.

Therefore, there is a need for a method for solving such problems.

### [Summary]

### [Technical Purpose]

A technical purpose to be achieved by the present disclosure is to provide a light-emitting element and a display device using the same, capable of achieving a high-luminance light-emitting element and display by concentrating light-emitted toward a lower portion of the light-emitting element toward a front side of the light-emitting element.

In addition, the present disclosure is intended to provide a light-emitting element and a display device using the same, in which a luminance deviation of the light-emitting element for each viewing angle may be reduced.

In addition, the present disclosure is intended to provide a light-emitting element and a display device using the same, capable of achieving a high-quality display because a color viewing angle deviation for each color may be reduced.

The present disclosure is intended to provide a light-emitting element and a display device using the same, capable of preventing a crack from occurring in a thin portion of the light-emitting element due to pressure applied to the light-emitting element in a process of transferring the light-emitting element to a wiring substrate.

In addition, the present disclosure is intended to provide a light-emitting element and a display device using the same, in which the light-emitting element may be mounted on a wiring substrate and electrical connection with wiring may be facilitated from an upper side of the wiring substrate.

The present disclosure is intended to provide a light-emitting element and a display device using the same, in which ohmic contact at room temperature and low temperature may be possible through a first contact portion and a second contact portion.

Furthermore, according to another embodiment of the present disclosure, those skilled in the art will understand from the entire spirit of the specification and drawings that there may be additional technical purposes not mentioned herein.

### [Technical Solutions]

As a first aspect for achieving the above technical purpose, the present disclosure may be configured to include: a support structure; a semiconductor structure disposed on the support structure and including a first conductive semiconductor layer, a light-emitting layer disposed on the first conductive semiconductor layer, and a second conductive semiconductor layer disposed on the light-emitting layer and including an expanded region having an area greater than an area of the light-emitting layer, wherein the expanded region has a first surface defining a light-emitting surface and a second surface opposite to the first surface; a first electrode disposed on the first conductive semiconductor layer; a reflective electrode in contact with the first electrode and including an extension region having a first contact portion; a second electrode in contact with the second surface and having a second contact portion; and a passivation layer disposed on at least one surface of the semiconductor structure and including a region between the reflective electrode and the second electrode.

In an embodiment, the first surface may be a surface facing a growth substrate for the semiconductor structure.

In an embodiment, the semiconductor structure may include a nitride-based semiconductor layer, and the second surface may be a gallium face (Ga-face).

In an embodiment, the semiconductor structure may have an inverted mesa shape.

In an embodiment, the reflective electrode may cover at least a portion of the mesa shape.

In an embodiment, the support structure may include a light-transmissive support layer, and an adhesive layer disposed between the support layer and the reflective electrode.

In an embodiment, the adhesive layer may include a reworkable adhesive layer.

In an embodiment, the first contact portion and the second contact portion may face the light-emitting surface.

In an embodiment, the first contact portion and the second contact portion may be disposed to face opposite sides of the light-emitting surface, respectively.

In an embodiment, the passivation layer may be formed to electrically insulate the first contact portion and the second contact portion from each other.

In an embodiment, the first contact portion and the second contact portion may be formed to be exposed on a surface opposite to the support structure.

As a second aspect for achieving the above technical purpose, the present disclosure may be configured to include: a support structure; a first conductive semiconductor layer disposed on the support structure; a light-emitting layer disposed on the first conductive semiconductor layer; a second conductive semiconductor layer disposed on the light-emitting layer and including an expanded region having an area greater than an area of the light-emitting layer, wherein the expanded region has a first surface having a first polarity and defining a light-emitting surface, and a second surface having a second polarity and opposite to the first surface; a first electrode disposed on the first conductive semiconductor layer; a reflective electrode in contact with the first electrode and including an extension region having a first contact portion; a second electrode in contact with the second surface and having a second contact portion; and a passivation layer disposed on at least a side surface of the light-emitting layer.

In an embodiment, the first polarity and the second polarity may be polarities generated according to characteristics of a semiconductor growth surface.

In an embodiment, the second conductive semiconductor layer may include a nitride-based semiconductor layer, and the second surface may be a gallium face (Ga-face).

In an embodiment, the first surface may be a surface facing a growth substrate on which the second conductive semiconductor layer is grown.

In an embodiment, at least a portion of the first conductive semiconductor layer, the light-emitting layer, and the second conductive semiconductor layer may have an inverted mesa shape.

As a third aspect for achieving the above technical purpose, the present disclosure may be configured to include: a light-emitting element disposed on a wiring substrate to define an individual pixel; and a molding layer disposed on the light-emitting element, wherein the light-emitting element includes: a support structure; a semiconductor structure disposed on the support structure and including a first conductive semiconductor layer, a light-emitting layer disposed on the first conductive semiconductor layer, and a second conductive semiconductor layer disposed on the light-emitting layer and including an expanded region having an area greater than an area of the light-emitting layer, wherein the expanded region has a first surface defining a light-emitting surface and a second surface opposite to the first surface; a first electrode disposed on the first conductive semiconductor layer; a reflective electrode in contact with the first electrode and including an extension region having a first contact portion facing the first surface; a second electrode in contact with the second surface and having a second contact portion and facing the first surface; and a passivation layer disposed on at least one surface of the semiconductor structure and including a region between the reflective electrode and the second electrode.

In an embodiment, the display device may further include a first wiring disposed on the wiring substrate and in contact with and connected to the first contact portion; and a second wiring disposed on the wiring substrate and in contact with and connected to the second contact portion

In an embodiment, the support structure may include an adhesive layer disposed between an upper surface of the wiring substrate and the reflective electrode.

In an embodiment, the passivation layer may be formed to electrically insulate the first contact portion and the second contact portion from each other.

In an embodiment, each of the first contact portion and the second contact portion may be formed such that a surface of each of the first contact portion and the second contact portion opposite to a surface thereof facing the support structure is exposed.

### [Advantageous Effects]

First, according to one embodiment of the present disclosure, light-emitted toward a lower portion may be collected toward a front side of the light-emitting element by a mesa structure and a reflective electrode structure, thereby achieving a high-luminance light-emitting element and display.

In addition, a reflective electrode disposed on an inclined portion of a mesa shape formed at an obtuse angle and an upper light extraction structure may reduce a luminance deviation for each viewing angle. In addition, a color viewing angle deviation for each color may be reduced, thereby achieving a high-quality display.

In a process of transferring a light-emitting element to a wiring substrate, it is possible to prevent a crack from occurring in a thin portion of the light-emitting element due to pressure applied to the light-emitting element.

In addition, although the light-emitting element has an overall flip-chip form, the first contact portion and the second contact portion extend leftward and rightward, so that the light-emitting element may be mounted on a wiring substrate and electrical connection with wiring may be facilitated from an upper side of the wiring substrate.

The ohmic contact at room temperature and low temperature may be possible through the first contact portion and the second contact portion. Accordingly, it is possible to prevent damage to a support layer vulnerable to heat.

Furthermore, according to still another embodiment of the present disclosure, there are additional technical effects not mentioned herein. Those skilled in the art may understand such additional technical effects from the entire spirit of the specification and drawings.

### [Brief Description of the Drawings]

FIG. 1 is a plan view illustrating a light-emitting element according to one embodiment of the present disclosure.
FIG. 2 is a cross-sectional view illustrating a light-emitting element according to one embodiment of the present disclosure.
FIG. 3 is a cross-sectional view illustrating an example in which a light-emitting element according to one embodiment of the present disclosure is used as a pixel of a display device.
FIGS. 4 to 15 are cross-sectional views illustrating a manufacturing process of a light-emitting element according to one embodiment of the present disclosure.
FIGS. 16 to 21 are cross-sectional views illustrating a process of manufacturing a display device using a light-emitting element according to one embodiment of the present disclosure.
FIG. 22 is a cross-sectional view illustrating a unit pixel of a display device using a light-emitting element according to one embodiment of the present disclosure.
FIG. 23 is a plan view illustrating a unit pixel of a display device using a light-emitting element according to one embodiment of the present disclosure.

### [Best Mode]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, area or module is described as being "on" another element, it is to be understood that the element may be directly on the other element or there may be an intermediate element between them.

The display device described in the present specification is a concept that includes any display device that displays information through a unit pixel or a set of unit pixels. Therefore, the concept is not limited to a finished product but may also be applied to a component thereof. For example, a panel corresponding to a component of a digital TV independently corresponds to the display device in the present specification. The finished product may include a mobile phone, a smart phone, a laptop computer, a digital broadcasting terminal, a personal digital assistant (PDA), a portable multimedia player (PMP), a navigation device, a slate PC, a tablet PC, an ultra-book, a digital TV, a desktop computer, and the like.

However, it will be readily apparent to those skilled in the art that the configuration according to the embodiment described in the present specification may also be applied to a device capable of displaying information, even if it is a new product form to be developed in the future.

In addition, the semiconductor light emitting device mentioned in this specification is a concept including an LED, a micro LED, and the like, which may be used in a mixed manner.

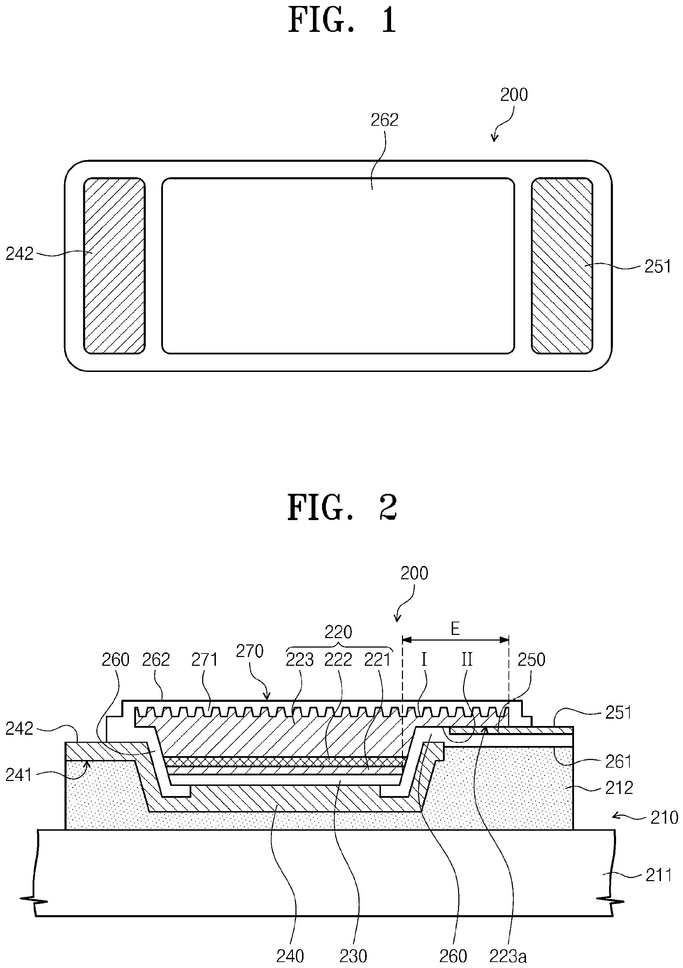

FIG. 1 is a plan view illustrating a light-emitting element according to one embodiment of the present disclosure. FIG. 2 is a cross-sectional view illustrating a light-emitting element according to one embodiment of the present disclosure.

Referring to FIGS. 1 and 2, in a light-emitting element 200 according to one embodiment, a first contact portion 242 and a second contact portion 251 may be disposed on the same plane with respect to a light-emitting surface I. In addition, the first contact portion 242 and the second contact portion 251 may be disposed on both end sides with respect to the light-emitting surface I. That is, the first contact portion 242 and the second contact portion 251 may be disposed on opposite sides with respect to the light-emitting surface I. In FIG. 1, the light-emitting surface I is illustrated in a state of being covered with a passivation layer 260.

As a specific example, the light-emitting element 200 according to one embodiment may include a support structure 210 and a semiconductor structure 220 disposed on the support structure 210.

The semiconductor structure 220 may include a first conductive semiconductor layer 221, a light-emitting layer 222 disposed on the first conductive semiconductor layer 221, and a second conductive semiconductor layer 223 disposed on the light-emitting layer 222. For example, the first conductive semiconductor layer 221 may be a P-type semiconductor layer, and the second conductive semiconductor layer 223 may be an N-type semiconductor layer. Hereinafter, a case in which the first conductive semiconductor layer 221 is a P-type semiconductor layer and the second conductive semiconductor layer 223 is an N-type semiconductor layer will be described as an example.

The semiconductor structure 220 may have a light-emitting structure capable of emitting red, green, or blue light. In addition, the semiconductor structure 220 may form a mini LED having a size in a millimeter unit or a micro LED having a size in a micrometer unit.

The second conductive semiconductor layer 223 may include an expanded region E having an area greater than an area of the light-emitting layer 222. In this regard, the expanded region E may have a first surface I defining a light-emitting surface and a second surface II opposite to the first surface I.

A first electrode 230 may be disposed on one surface of the first conductive semiconductor layer 221. The first conductive semiconductor layer 221 may form ohmic contact with the first electrode 230. For example, the first electrode 230 may include a transparent conductive oxide layer such as indium tin oxide (ITO).

A reflective electrode 240 electrically connected to the first electrode 230 may be disposed on one surface of the first electrode 230. The reflective electrode 240 may include an extension region 241 having a first contact portion 242. For example, the reflective electrode 240 may include at least one of aluminum (Al) and silver (Ag).

A second electrode 250 in contact with the second surface II of the second conductive semiconductor layer 223 may be disposed. The second electrode 250 may include a second contact portion 251. For example, the second electrode 250 may include gold (Au). As a specific example, the second electrode 250 may include at least one of chromium (Cr), platinum (Pt), and gold (Au).

A passivation layer 260 may be disposed on at least one surface of the semiconductor structure 220. For example, the passivation layer 260 may be disposed on at least a side surface of the light-emitting layer 222. As another example, the passivation layer 260 may be disposed on a side surface of the semiconductor structure 220. The passivation layer 260 may include a first portion 261 disposed between the second electrode 250 and the support structure 210. In addition, the passivation layer 260 may include a second portion 262 disposed on the light-emitting surface I.

In an embodiment, the semiconductor structure 220 may have an inverted mesa shape. For example, the semiconductor structure 220 may have an inverted horizontal light-emitting element structure. In an embodiment, the reflective electrode 240 may cover at least a portion of the mesa shape. For example, the reflective electrode 240 may be provided to surround the inverted mesa shape.

In addition, a side angle of the mesa shape or mesa structure is formed as an obtuse angle. In this case, the obtuse angle of the side surface may not only be set to a predetermined single angle, but may also be formed at different angles in consideration of a wavelength of light-emitted from the light-emitting layer, for example, a light emission color such as R, G, or B, or a luminance deviation for each viewing angle.

In this case, the light-emitting surface I may form a surface extending along a growth surface on which the semiconductor structure 220 is grown. In other words, the light-emitting surface I may be a surface facing a growth substrate on which the semiconductor structure 220 is grown. That is, the first surface I may be a surface on a side of the growth substrate on which the semiconductor structure 220 is grown. In an embodiment, the semiconductor structure 220 may include a nitride-based semiconductor layer such as gallium nitride (GaN). In this case, the first surface I may be a nitrogen face (N-face), and the second surface II may be a gallium face (Ga-face).

A gallium nitride semiconductor may have polarity according to a direction of atomic arrangement (Ga-N) in a growth direction. For example, the first surface I may have a first polarity, and the second surface II may have a second polarity. The first surface I and the second surface II may have different states for ohmic contact. For example, the first surface I and the second surface II may have different work functions.

In this regard, the second electrode 250 may be connected on the second surface II of the second conductive semiconductor 223. That is, when the second conductive semiconductor layer 223 includes a nitride-based semiconductor layer, the second surface II may be a gallium face (Ga-face). The second electrode 250 in contact with the second surface II may be formed through a room-temperature process. For example, the second electrode 250 may form ohmic contact on the second surface II through a room-temperature or low-temperature process.

A light extraction structure 270 may be formed on the first surface I forming the light-emitting surface. For example, the light extraction structure 270 having a rough surface or a concave-convex structure 271 may be provided on the first surface I. The second portion 262 of the passivation layer 260 may be disposed on the light extraction structure 270.

In an embodiment, the support structure 210 may include a light-transmissive support layer 211 and an adhesive layer 212 disposed between the support layer 211 and the reflective electrode 240. The support layer 211 may be removed when the light-emitting element is later mounted on a wiring substrate 100 constituting a display device.

For example, the adhesive layer 212 of the support structure 210 may include a reworkable adhesive layer. That is, when light is irradiated through the light-transmissive support layer 211, the support layer 211 may be separated from the adhesive layer 212. The light-emitting element 200 from which the support layer 211 is separated in this manner may be mounted on the wiring substrate 100. In this regard, the light-emitting element 200 may be attached onto the wiring substrate 100 through the adhesive layer 212.

In general, in order to secure luminance of a display using a small light-emitting element, for example, one micro LED as a subpixel, it is advantageous for an LED chip itself to have excellent optical efficiency.

As a size of a device decreases, an area of a side wall relative to an active area may increase, current leakage may increase, and optical efficiency may decrease. Thus, when a light-emitting element is used in a display, it may be difficult to implement high luminance.

Even when a method of increasing optical efficiency by forming roughness on the device itself is adopted, a large amount of light escapes to a lower portion and a side surface of the device. Thus, in a display in which front luminance is important, a method for further increasing optical efficiency is required.

In addition, red, green, and blue light-emitting elements are made of different semiconductor thin film materials, and thus have different light emission distributions for respective viewing angles, which may cause a problem in that colors appear differently for respective viewing angles in a display.

In a structure in which a display is manufactured by connecting wiring to an upper portion of a device, there is a problem in that it is difficult to use a flip-chip structure. When lower wiring is connected in order to use the flip-chip structure, bonding needs to be performed through a solder material, and spreading of the solder material during bonding may cause a short-circuit defect between two electrodes of the device. Therefore, when a flip-chip structure is manufactured in a display, a minimum distance between the two electrodes should be secured, and thus it may be difficult to reduce a size of the device.

However, according to an embodiment of the present disclosure, as described above, like an inverted horizontal LED (light-emitting diode) structure, the first contact portion 242, which is a P-contact, and the second contact portion 251, which is an N-contact, may be disposed on the same surface, and the first contact portion 242 and the second contact portion 251 may be electrically insulated by the passivation layer 262.

In addition, the reflective electrode 240 surrounding the first contact portion 242, the second contact portion 251, and the entire lower portion of the semiconductor structure 220 may be provided. In addition, the support structure 210 including a bonding material such as BCB, that is, the adhesive layer 212, may be disposed under the reflective electrode 240. In this regard, a separate bonding layer may be further provided between the reflective electrode 240 and the adhesive layer 212 to increase bonding force.

The first contact portion 242 and the second contact portion 251 extending from the first electrode 230 and the second electrode 250 may be disposed on a side surface of the light-emitting element 200 along the support structure 210. Therefore, when the light-emitting element 200 is transferred onto the wiring substrate 100, the first contact portion 242 and the second contact portion 251 may be exposed to a surface opposite to the support structure 210 so that wiring connection may be performed from above.

The light-emitting element according to an embodiment of the present disclosure as described above may collect light-emitted toward a lower portion toward a front side of the light-emitting element by a mesa structure and a reflective electrode 240 structure, thereby achieving a high-luminance light-emitting element and display.

In addition, the reflective electrode 240 disposed on the inclined portion of the mesa shape formed at an obtuse angle and the upper light extraction structure 270 may reduce a luminance deviation for each viewing angle. In addition, a color viewing angle deviation for each color may be reduced, thereby achieving a high-quality display.

In a process of transferring the light-emitting element 200 to the wiring substrate 100, it is possible to prevent a crack from occurring in a thin portion of the light-emitting element 200 due to pressure applied to the light-emitting element 200.

In addition, although the light-emitting element 200 has an overall flip-chip form, the first contact portion 242 and the second contact portion 251 extend leftward and rightward, so that the light-emitting element 200 may be mounted on the wiring substrate 100 and electrical connection with wiring may be facilitated from an upper side of the wiring substrate 100.

ohmic contact at room temperature and low temperature may be possible through the first contact portion 242 and the second contact portion 251. Accordingly, it is possible to prevent damage to the support layer 211 vulnerable to heat.

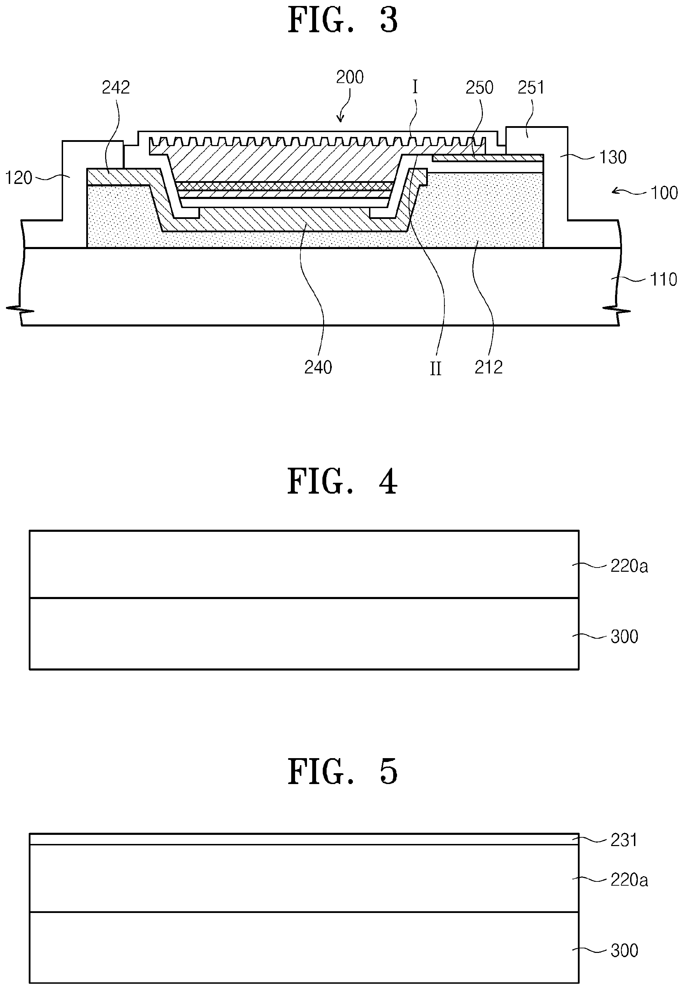

FIG. 3 is a cross-sectional view illustrating an example in which a light-emitting element according to one embodiment of the present disclosure is used as a pixel of a display device.

Referring to FIG. 3, a state is illustrated in which the light-emitting element 200 is mounted on the wiring substrate 100 and wiring is formed.

The wiring substrate 100 includes a panel substrate 110, and the light-emitting element 200 may be mounted on an upper surface of the panel substrate 110. In this regard, the support layer 211 of the light-emitting element 200 may be removed, and the light-emitting element 200 may be installed on the upper surface of the panel substrate 110 by the adhesive layer 212. Accordingly, the support structure 210 may include the adhesive layer 212 disposed between the upper surface of the wiring substrate 100 and the reflective electrode 240.

In this regard, on the wiring substrate 100, the first contact portion 242 of the light-emitting element 200 may be electrically connected by a first wiring 120, and the second contact portion 251 may be electrically connected by a second wiring 130. The first wiring 120 and the second wiring 130 may be connected to the light-emitting element 200 through an upper surface of the light-emitting element 200, respectively.

As described above, the light-emitting element 200 may have an overall flip-chip form. In this regard, the first contact portion 242 and the second contact portion 251 extend leftward and rightward, and thus may be electrically connected to the wiring substrate 100 by the first wiring 120 and the second wiring 130. In addition, since the first contact portion 242 and the second contact portion 251 face the upper surface, that is, a surface opposite to the wiring substrate, the light-emitting element 200 may be mounted on the wiring substrate 100 and electrical connection with the wiring may be facilitated from an upper side of the wiring substrate 100.

A display device using the light-emitting element 200 will be described later in detail.

FIGS. 4 to 15 are cross-sectional views illustrating a manufacturing process of a light-emitting element according to one embodiment of the present disclosure.

Hereinafter, a manufacturing process of the light-emitting element according to one embodiment will be described step by step with reference to each cross-sectional view.

First, referring to FIG. 4, a semiconductor thin film 220a may be formed on a growth substrate 300. For example, the semiconductor thin film 220a may include an N-type semiconductor layer 223, a light-emitting layer 222, and a P-type semiconductor layer 221.

The semiconductor thin film 220a may be formed over an entire area of the growth substrate 300 in a wafer form.

Thereafter, referring to FIG. 5, a first electrode layer 231 may be formed on the semiconductor thin film 220a. As described above, the first electrode layer 231 may be formed of a transparent conductive oxide such as ITO.

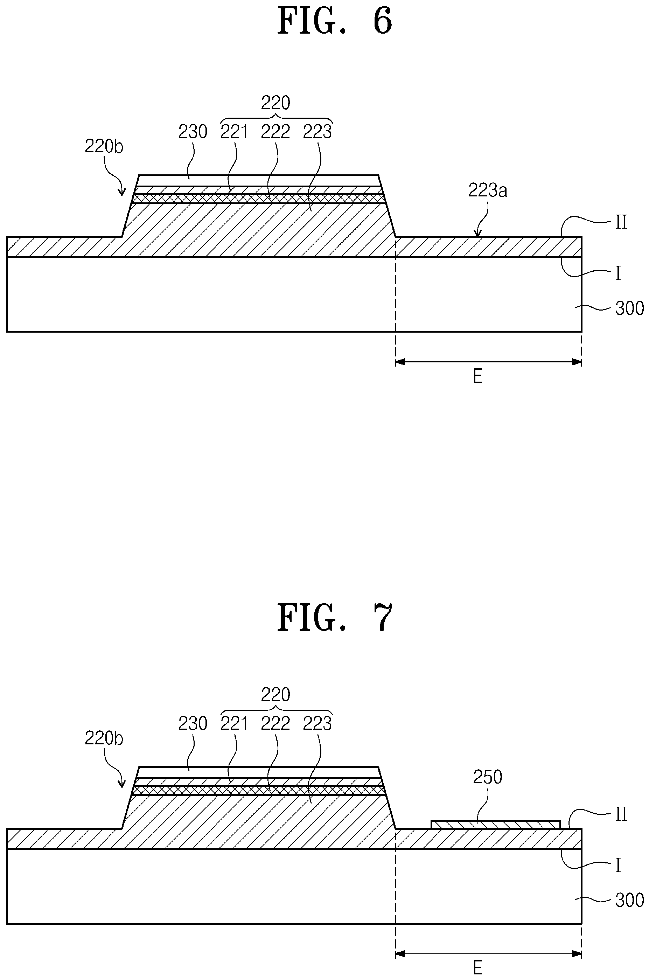

Next, referring to FIG. 6, a mesa shape 220b, that is, a mesa structure, may be formed. For example, mesa etching may be performed by a dry etching method to form the mesa shape 220b. The mesa structure 220b may be formed for each individual light-emitting element. For example, a plurality of mesa shapes 220b may be formed on the growth substrate 300.

In this regard, an opening 223a through which a portion of the second conductive semiconductor layer 223, that is, the N-type semiconductor layer, is exposed may be formed for formation of the second electrode 250. The opening 223a may form the expanded region E described above. For example, the expanded region E may be formed for formation of the second electrode 250. The expanded region E may include the first surface I and the second surface II. In this regard, when a gallium nitride-based semiconductor is formed, the first surface I may form a gallium face, which is a growth surface, and the second surface II may form a nitrogen face.

Thereafter, referring to FIG. 7, the second electrode 250 may be formed in the opening 223a. As described above, the second electrode 250 may be formed on the second surface II forming the nitrogen face in the second conductive semiconductor layer 223.

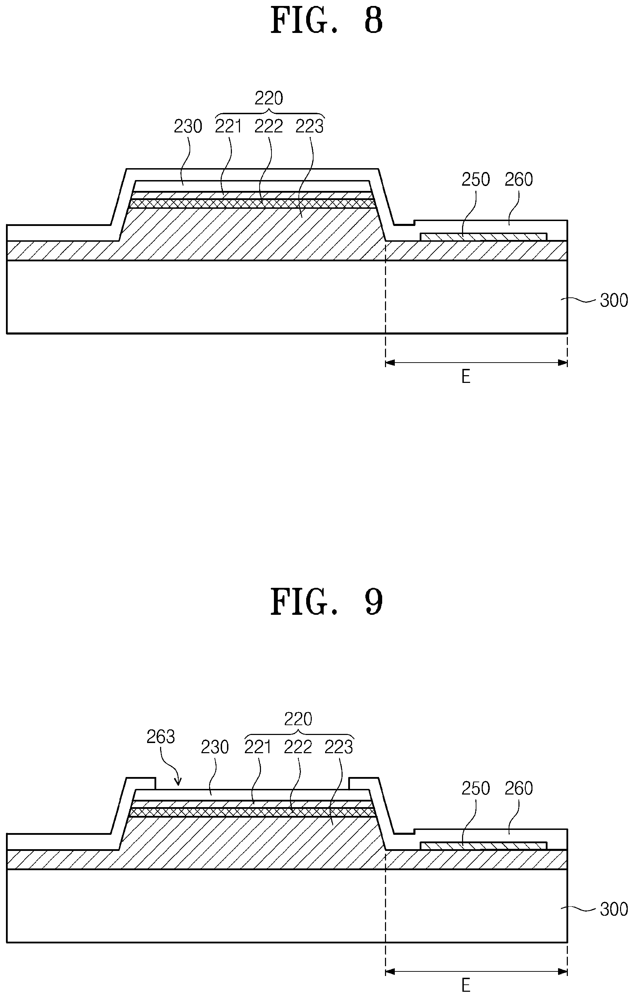

Next, referring to FIG. 8, a passivation layer 260 may be formed on an upper surface of the semiconductor structure 220 on which the first electrode 230 and the second electrode 250 are formed. The passivation layer 260 may be formed to cover the entire upper surface.

Thereafter, referring to FIG. 9, at least a portion of the passivation layer 260 covering the first electrode 230 and the second electrode 250 may be removed. For example, the first electrode 230 may be opened, and the second electrode 250 may not be opened.

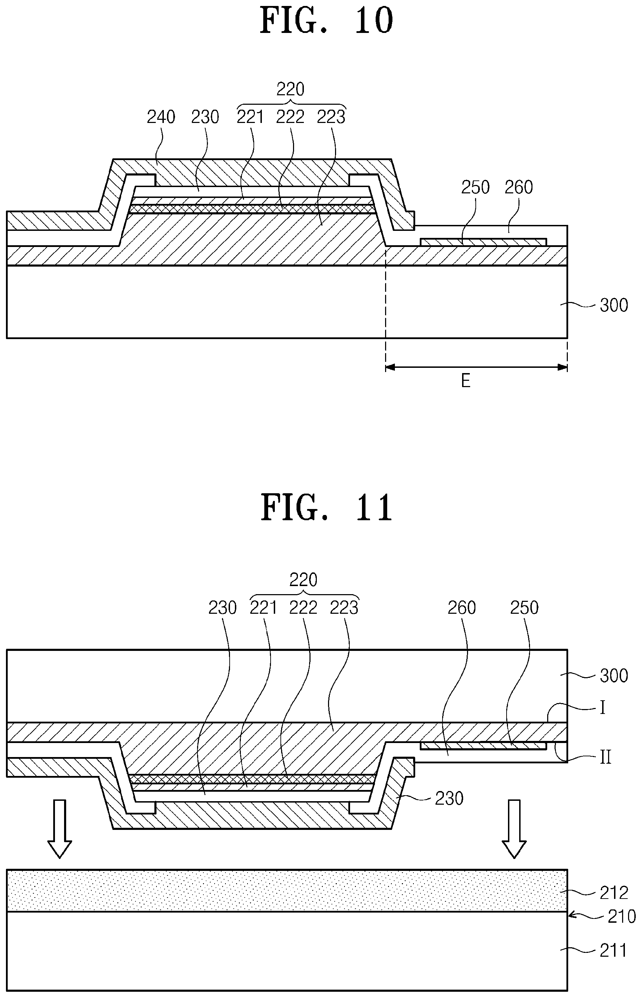

Referring to FIG. 10, a reflective electrode 240 covering at least the mesa shape 220b and the first electrode 230 may be formed. The reflective electrode 240 may be formed in a region excluding the expanded region E. The reflective electrode 240 may be electrically connected to the first electrode 230. The passivation layer 260 may be disposed between the reflective electrode 240 and the semiconductor structure 220.

Next, referring to FIG. 11, the support structure 210 may be bonded to the upper surface of the structure of FIG. 10. For example, the structure illustrated in FIG. 10 may be inverted and bonded onto the support structure 210. In this regard, the reflective electrode 240 and a portion of the passivation layer 260 are adhered to the adhesive layer 212 and positioned on the support layer 211.

Accordingly, the mesa shape 220b having an inverted shape may be disposed on the support structure 210. The mesa shape 220b may be covered by the reflective electrode 240.

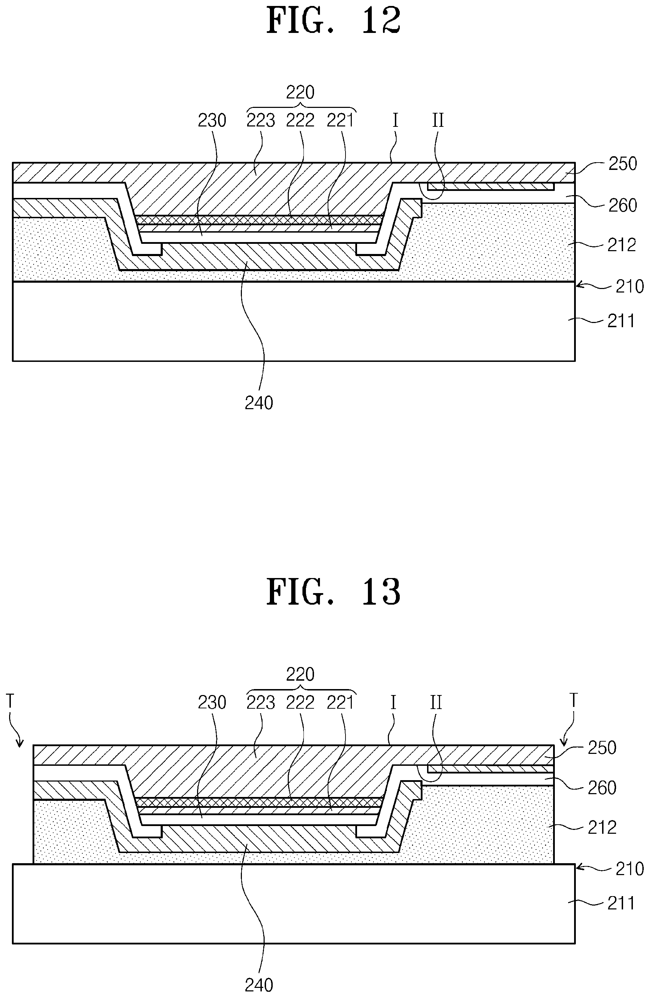

Thereafter, as illustrated in FIG. 12, the growth substrate 300 may be removed. In this process, the light-emitting surface I may be exposed.

Next, referring to FIG. 13, a separation process for separating the structure into individual light-emitting elements 200 may be performed. For example, a trench T for distinguishing regions of the individual light-emitting elements 200 may be formed.

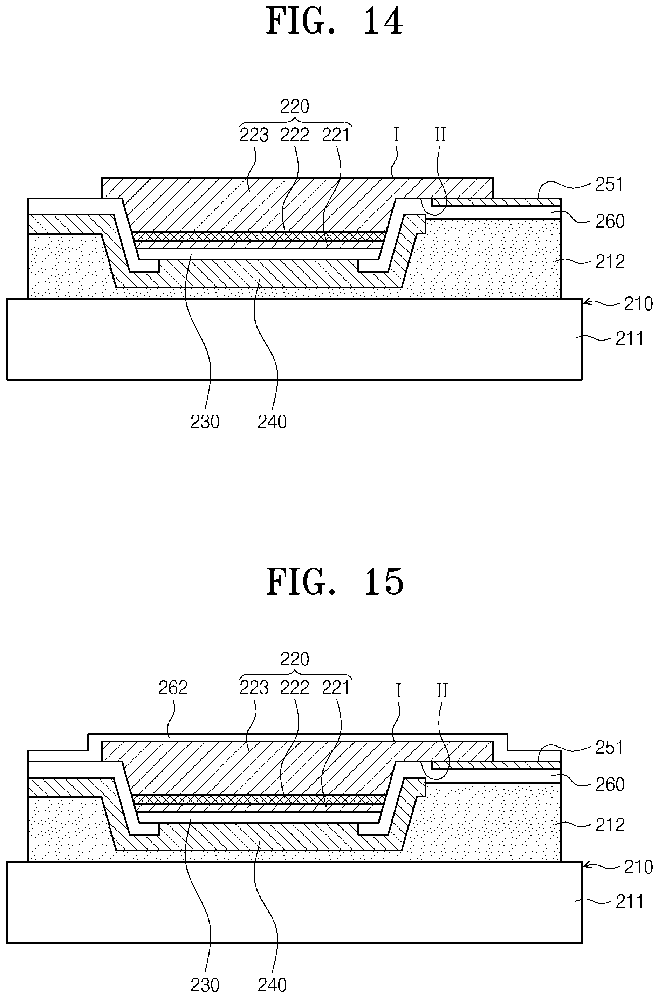

Thereafter, referring to FIG. 14, both sides of the semiconductor structure 220 may be etched so that at least a portion of parts corresponding to the first contact portion 242 and the second contact portion 251 is exposed.

By the etching process, the second contact portion 251 is exposed, and a portion of the passivation layer 260 in a region corresponding to the first contact portion 242 is exposed.

Next, referring to FIG. 15, a passivation layer 262, that is, a second portion, may be formed on an upper surface of the semiconductor structure 220 so as to cover the light-emitting surface.

Thereafter, when portions of the passivation layer 260 corresponding to the first contact portion 242 and the second contact portion 251 are removed, a structure as illustrated in FIG. 2 may be formed.

Although not separately described above, when the semiconductor structure 220 is grown on the growth substrate 300, if a patterned sapphire substrate (PSS) is used, the light extraction structure 270 may be formed in a process of removing the growth substrate 300. Alternatively, the light extraction structure 270 may be formed on the light-emitting surface I through a separate etching process.

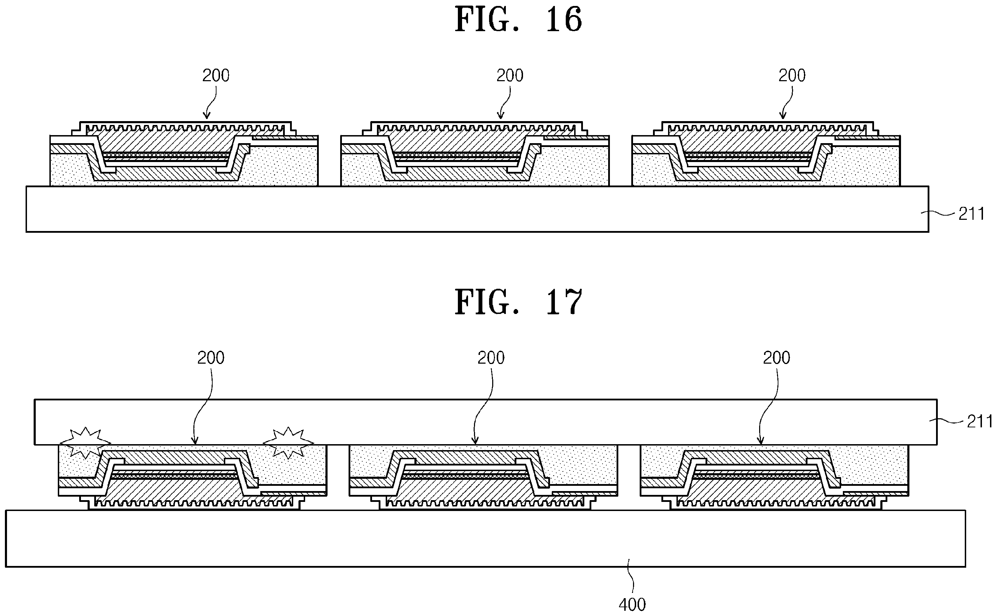

FIGS. 16 to 21 are cross-sectional views illustrating a process of manufacturing a display device using a light-emitting element according to one embodiment of the present disclosure.

First, referring to FIG. 16, a state is illustrated in which a plurality of light-emitting elements 200 are manufactured on the support layer 211. In this regard, the plurality of light-emitting elements 200 may be light-emitting elements 200 having semiconductor structures 220 that emit light of the same color.

Referring to FIG. 17, in order to transfer the light-emitting elements 200 onto the wiring substrate 100, first, a temporary substrate 400 may be attached to a side of the light-emitting surface I of the light-emitting element 200.

Thereafter, the support layer 211 may be removed. For example, by irradiating light through the support layer 211, the adhesive layer 212 may be deformed, and the support layer 211 and the adhesive layer 212 may be separated from each other.

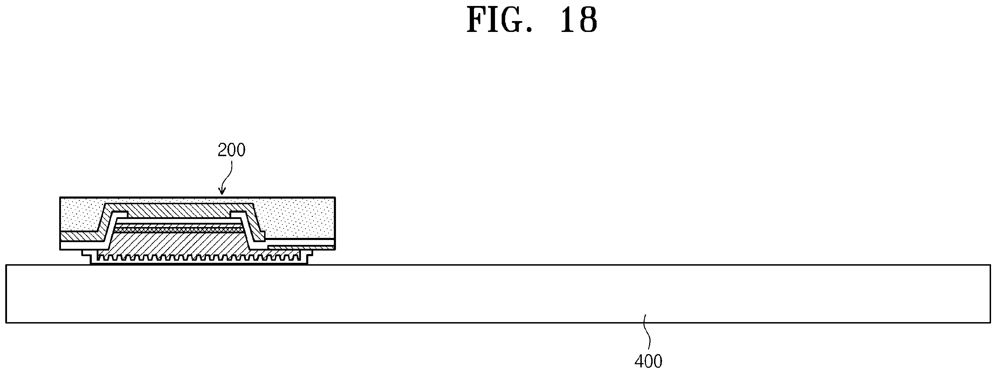

Referring to FIG. 18, a unit light-emitting element 200 may be transferred to one pixel region. For example, when the light-emitting element 200 is a light-emitting element 200 emitting blue light, one blue light-emitting element 200 may be provided in one pixel region. Accordingly, one light-emitting element 200 may be separated from the support layer 211 and transferred to the temporary substrate 400.

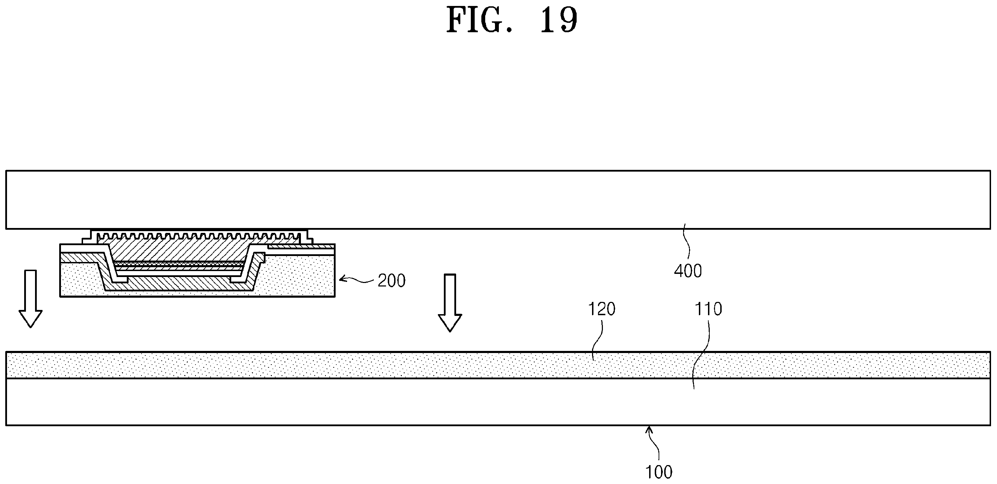

Thereafter, referring to FIG. 19, the light-emitting element 200 transferred to the temporary substrate 400 may be transferred to the wiring substrate 100.

For example, a surface from which the support layer 211 is removed may be bonded onto the wiring substrate 100 including a bonding layer 120 on the panel substrate 110. That is, the light-emitting element 200 may be transferred onto the wiring substrate 100 such that the adhesive layer 212 is adhered to the bonding layer 120.

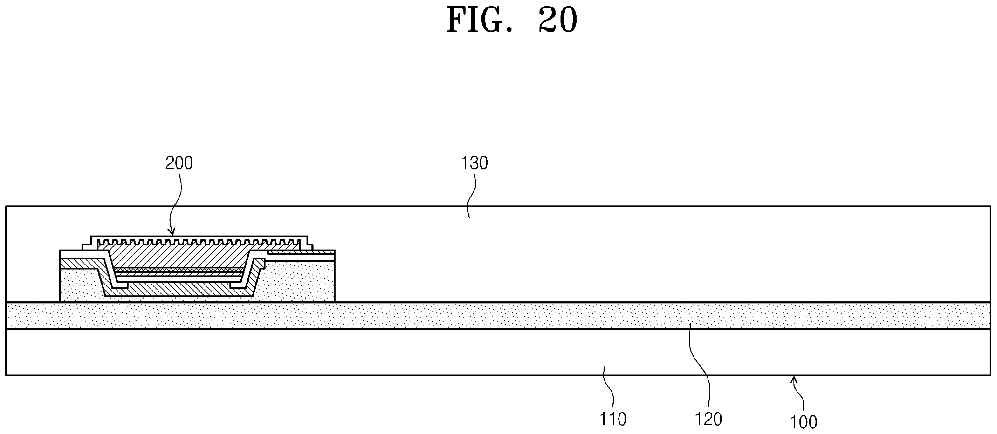

Next, referring to FIG. 20, a molding layer 132 may be formed to a height covering at least the light-emitting element 200. The molding layer 132 may planarize a height deviation caused by the light-emitting element 200.

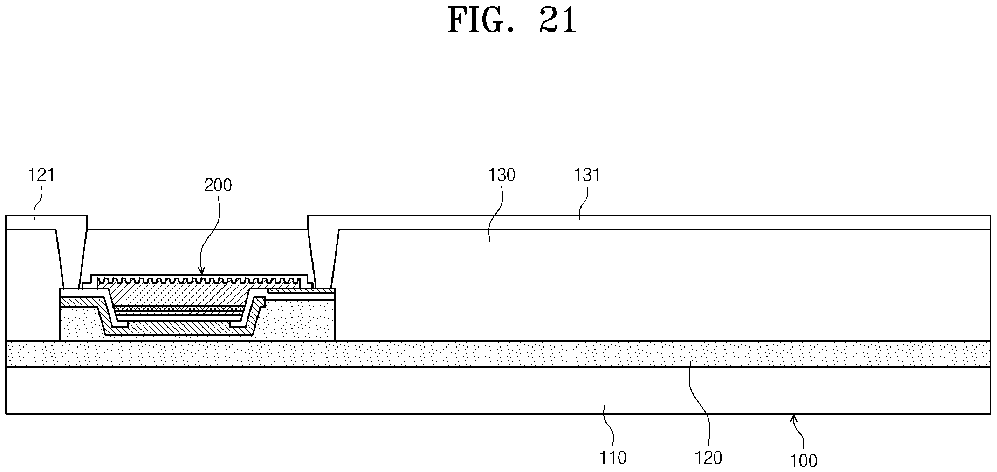

Thereafter, referring to FIG. 21, after a portion of the molding layer 132 is removed so that the first contact portion 242 and the second contact portion 251 of the light-emitting element 200 are exposed, a first wiring 121 and a second wiring 131 may be formed to be bonded to the first contact portion 242 and the second contact portion 251, respectively.

The first wiring 121 and the second wiring 131 may be formed on the molding layer 132, respectively, and may be bent toward the light-emitting element 200 to be electrically connected to the first contact portion 242 and the second contact portion 251.

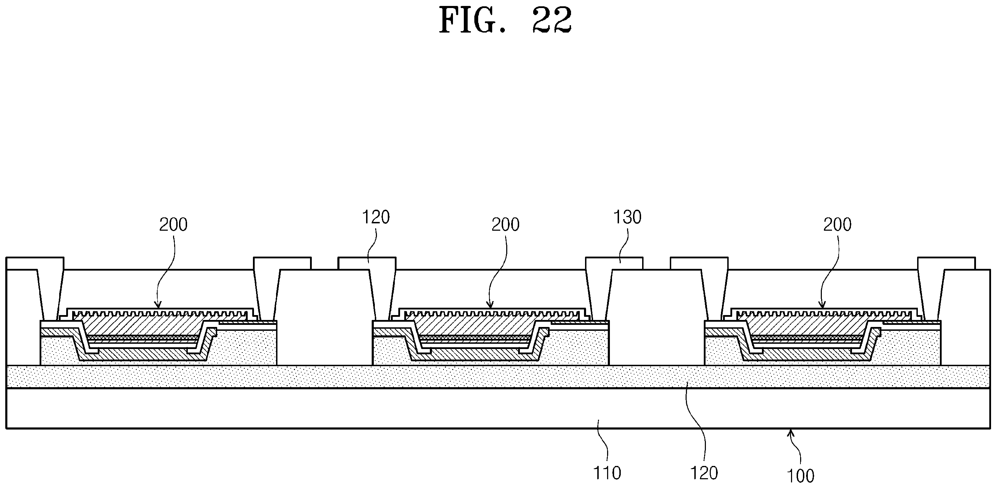

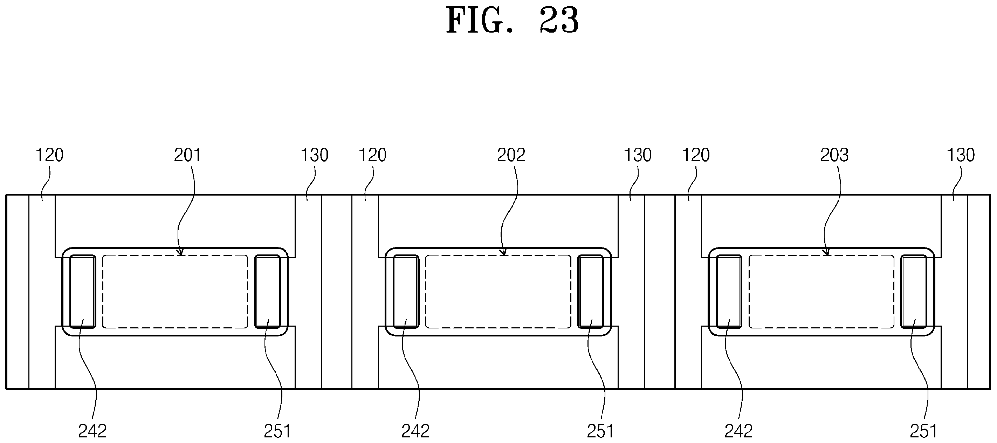

FIG. 22 is a cross-sectional view illustrating a unit pixel of a display device using a light-emitting element according to one embodiment of the present disclosure. FIG. 23 is a plan view illustrating a unit pixel of a display device using a light-emitting element according to one embodiment of the present disclosure.

Referring to FIGS. 22 and 23, other light-emitting elements 201 and 202 constituting a unit pixel may be transferred together and installed by the same process as the process described above with reference to FIGS. 16 to 21. That is, a blue light-emitting element 200, a green light-emitting element 201, and a red light-emitting element 202 may be transferred adjacent to each other on the wiring substrate 100 to constitute a unit pixel.

The light-emitting elements 200, 201, and 202 constituting the unit subpixel light sources may be installed while being electrically connected to the first wiring 120 and the second wiring 130, respectively, above the molding layer 132. For example, the first contact portions 242 and the second contact portions 251 of the light-emitting elements 200, 201, and 202 may be electrically connected to the first wiring 120 and the second wiring 130, respectively, thereby implementing a unit pixel. It goes without saying that a plurality of such unit pixels may be provided in the display device.

The foregoing description is merely illustrative of the present invention, and various modifications and variations may be made by those skilled in the art to which the present invention pertains without departing from the essential features of the present invention.

Accordingly, the embodiments disclosed herein are intended to illustrate the present invention and not to limit the present invention, and the scope of the present invention is not limited by such embodiments.

The scope of protection of the present invention shall be determined by the appended claims, and all modifications and equivalents falling within the scope of the claims are intended to be included within the scope of the present invention.

### [Description of Reference Numerals]

| | | | |
|---|---|---|---|
| 100: | Wiring substrate | 110: | Panel substrate |
| 120, 121: | First wiring | 130, 131: | Second wiring |
| 132: | Molding layer | | |
| 200: | Light-emitting element | 210: | Support structure |
| 220: | Semiconductor structure | 230: | First electrode |
| 240: | Reflective electrode | 250: | Second electrode |
| 260: | Passivation layer | 270: | Light extraction structure |

## Claims

1. A light-emitting element comprising:
a support structure;
a semiconductor structure disposed on the support structure and including a first conductive semiconductor layer, a light-emitting layer disposed on the first conductive semiconductor layer, and a second conductive semiconductor layer disposed on the light-emitting layer and including an expanded region having an area greater than an area of the light-emitting layer, wherein the expanded region has a first surface defining a light-emitting surface and a second surface opposite to the first surface;
a first electrode disposed on the first conductive semiconductor layer;
a reflective electrode in contact with the first electrode and including an extension region having a first contact portion;
a second electrode in contact with the second surface and having a second contact portion; and
a passivation layer disposed on at least one surface of the semiconductor structure and including a region between the reflective electrode and the second electrode.

2. The light-emitting element of claim 1, wherein the first surface is a surface facing a growth substrate for the semiconductor structure.

3. The light-emitting element of claim 1, wherein the semiconductor structure includes a nitride-based semiconductor layer, and the second surface is a gallium face (Ga-face).

4. The light-emitting element of claim 1, wherein the semiconductor structure has an inverted mesa shape.

5. The light-emitting element of claim 4, wherein the reflective electrode covers at least a portion of the mesa shape.

6. The light-emitting element of claim 1, wherein the support structure includes:
a light-transmissive support layer; and
an adhesive layer disposed between the support layer and the reflective electrode.

7. The light-emitting element of claim 1, wherein the first contact portion and the second contact portion face the light-emitting surface.

8. The light-emitting element of claim 1, wherein the first contact portion and the second contact portion are disposed to face opposite sides of the light-emitting surface, respectively.

9. The light-emitting element of claim 1, wherein the passivation layer is formed to electrically insulate the first contact portion and the second contact portion from each other.

10. The light-emitting element of claim 1, wherein the first contact portion and the second contact portion are formed to be exposed on a surface opposited to the support structure.

11. The light-emitting element of claim 1, wherein the first surface has a first polarity, and the second surface has a second polarity.

12. The light-emitting element of claim 11, wherein the first polarity and the second polarity are polarities generated according to characteristics of a semiconductor growth surface.

13. The light-emitting element of claim 11, wherein the first surface is a surface facing a growth substrate on which the second conductive semiconductor layer is grown.

14. A display device comprising:
a light-emitting element disposed on a wiring substrate to define an individual pixel; and
a molding layer disposed on the light-emitting element,
wherein the light-emitting element includes:
a support structure;
a semiconductor structure disposed on the support structure and including a first conductive semiconductor layer, a light-emitting layer disposed on the first conductive semiconductor layer, and a second conductive semiconductor layer disposed on the light-emitting layer and including an expanded region having an area greater than an area of the light-emitting layer, wherein the expanded region has a first surface defining a light-emitting surface and a second surface opposite to the first surface;
a first electrode disposed on the first conductive semiconductor layer;
a reflective electrode in contact with the first electrode and including an extension region having a first contact portion facing the first surface;
a second electrode in contact with the second surface and having a second contact portion and facing the first surface; and
a passivation layer disposed on at least one surface of the semiconductor structure and including a region between the reflective electrode and the second electrode.

15. The display device of claim 14, further comprising:
a first wiring disposed on the wiring substrate and in contact with and connected to the first contact portion; and
a second wiring disposed on the wiring substrate and in contact with and connected to the second contact portion.

16. The display device of claim 14, wherein the support structure includes an adhesive layer disposed between an upper surface of the wiring substrate and the reflective electrode.

17. The display device of claim 14, wherein the semiconductor structure has an inverted mesa shape.

18. The display device of claim 14, wherein the reflective electrode covers at least a portion of the mesa shape.

19. The display device of claim 14, wherein the passivation layer is formed to electrically insulate the first contact portion and the second contact portion from each other.

20. The display device of claim 14, wherein the first contact portion and the second contact portion are foremd to be exposed on a surface opposite to the support structure.
